(19) Europäisches Patentamt
European Patent Office
Office européen des brevets

(11) EP 2 940 481 A1

(12) EUROPEAN PATENT APPLICATION

(43) Date of publication:
04.11.2015 Bulletin 2015/45

(21) Application number: 15165335.9

(22) Date of filing: 28.04.2015

(51) Int Cl.:
$G01R\ 19/25$ (2006.01)    $G01R\ 21/133$ (2006.01)
$H02M\ 7/00$ (2006.01)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA

(30) Priority: 29.04.2014 KR 20140051552

(71) Applicant: LSIS Co., Ltd.
Anyang-si, Gyeonggi-do 431-848 (KR)

(72) Inventor: Choi, Ho Seok
Anyang-si, Gyeonggi-do 431-848 (KR)

(74) Representative: Lang, Johannes
Bardehle Pagenberg Partnerschaft mbB
Patentanwälte, Rechtsanwälte
Prinzregentenplatz 7
81675 München (DE)

(54) **INSTANTANEOUS POWER MONITORING SYSTEM FOR HVDC SYSTEM**

(57) A high voltage direct current (HVDC) instantaneous power monitoring system is provided. The high voltage direct current (HVDC) instantaneous power monitoring system includes a calculation processing unit receiving three-phase current and voltage, detecting a synchronous phase angle from received three-phase current and voltage, and transforming two-phase data into two-phase data to output two-phase data; and a data processing unit storing data transformed at the calculation processing unit.

FIG.2

**Description**

**CROSS-REFERENCE TO RELATED APPLICATIONS**

The present application claims priority under 35 U.S.C. 119 and 35 U.S.C. 365 to Korean Patent Application No. 10-2014-0051552 (filed on April 29, 2014), which is hereby incorporated by reference in its entirety.

**BACKGROUND**

The present disclosure relates to an HVDC instantaneous power monitoring system.

There are two power system interconnection methods, one for interconnecting AC power systems as they are, and the other for converting AC power into DC power before interconnection between systems.

In recent, an interest in the method of converting the AC power into the DC power before interconnection between power systems is more increasing than the method of interconnecting AC power systems as they are.

A high voltage direct current (HVDC) transmission system using a power converter is also installed between Jeju island and Haenam-gun in Korea to interconnect power systems between Jeju island and Haenam-gun.

An HVDC transmission method is one of electricity transmission methods and indicates a supply method in which high voltage AC power generated at the power station is converted into DC power, which is transmitted and then re-converted into AC power in a desired power receiving region.

The DC transmission method has many advantages.

Firstly, since the size of a DC voltage is just about 70 of the maximum value of an AC voltage, the HVDC transmission system may easily perform device insulation and since there is a low voltage, it is possible to reduce the number of insulators installed in each device and the height of an iron tower.

Since the DC method has less transmission loss than an AC method when the HVDC transmission system transmits the same power, the best advantage of the HVDC transmission system is that power transmission efficiency may increase. The HVDC transmission system may transmit currents two or more times in the DC method than the AC method.

Since the HVDC transmission system may reduce wire consumption and the area of a transmission line, it is effective and also possible to enhance the stability of systems by connecting two systems having different voltages or frequencies.

The HVDC transmission system has no constraint on a power transmission distance and the DC transmission method needs inexpensive construction costs in land power transmission exceeding 450 Km or in submarine power transmission exceeding 40 Km as well.

Thus, the HVDC transmission system is used for a power system interconnection method of new renewable energy power, especially for power transmission of a large offshore wind farm.

Since in other countries such as China or India, the distance between a power station and an electricity user is 1000 Km or longer, the prevalence of the HVDC transmission system is rapidly increasing.

Such an HVDC system is classified into a current type HVDC system using a thyristor valve and a voltage type HVDC system using an insulated gate bipolar mode transistor (IGBT) element.

A domestic power transmission and distribution system has adopted a method of measuring three-phase current and voltage to monitor instantaneous power for the monitoring of all event situations including a fault current as well as a power flow and for data acquisition. The monitoring of power is performed at the bus-dependent substation of a transmission/distribution point and is also performed on each feeder interconnected to a bus.

Thus, the HVDC system also monitors AC power on rectifier-side and inverter-side converter stations for the same purpose.

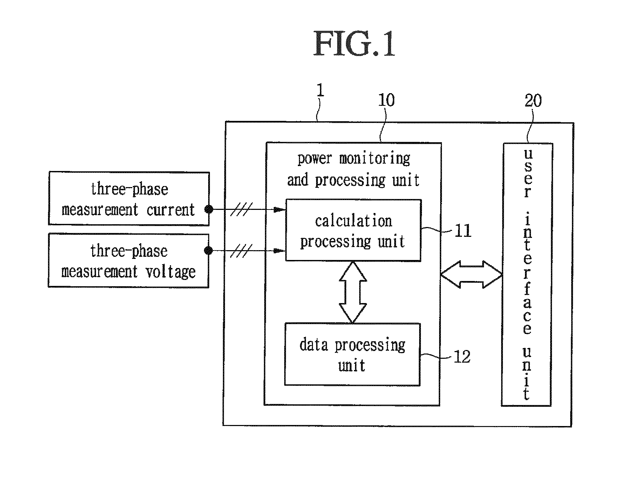

Fig. 1 is a diagram for explaining a typical HVDC instantaneous power monitoring system.

Referring to Fig. 1, a typical HVDC instantaneous power monitoring system 1 includes a configuration that may measure three-phase voltage and current and the phase difference for the monitoring of AC power to determine all event situations including whether a power transmission system normally operates and a fault situation.

In particular, a power monitoring and processing unit 10 includes a calculation processing unit 11 and a data processing unit 12. A design is generally made to store, as data, an event occurrence time and a voltage and current at that time when an event situation occurs, but the data processing unit 12 has a limit in data storage capacity. Thus, data stored for a certain period is deleted automatically or selectively by an operator through a user interface unit 20 to secure a storage space. If an event such as an accident and failure occurs in a power system while the storage space is not secured, there is a difficulty in ensuring an ability for analyzing the reason and solving the situation. Also, it may be difficult to check event data on a past history through random or batch deletion of pre-stored data.

**SUMMARY**

Embodiments provide a high voltage direct current (HVDC) instantaneous power monitoring system that may efficiently manage a data storage space through an algorithm design for instantaneous power analysis.

In one embodiment, a high voltage direct current (HVDC) instantaneous power monitoring system includes a calculation processing unit receiving three-phase current and voltage, detecting a synchronous phase angle from received three-phase current and voltage, and transforming two-phase data into two-phase data to output two-phase data; and a data processing unit storing data transformed at the calculation processing unit.

The calculation processing unit may include a synchronous phase angle detection unit detecting a synchronous phase angle from the three-phase current and voltage.

The calculation processing unit may include an instantaneous power three-phase to two-phase transformation processing unit performing first and second transformation on the three-phase data.

The instantaneous power three-phase to two-phase transformation processing unit may transform the three-phase data into two-phase Cartesian coordinate system data through Clarke transformation corresponding to the first transformation, and transform data obtained through the first transformation into a two-phase rotary synchronous coordinate system through Park transformation corresponding to the second transformation.

The Park transformation may be performed based on the synchronous phase angle detected by the synchronous phase angle detection unit.

The first transformation may transform the three-phase current into two-phase current, and

the second transformation may transform the two-phase current obtained through the transformation into two-phase current being a DC.

The instantaneous power three-phase to two-phase transformation processing unit may inversely perform the first and second transformation on the two-phase current obtained through the first and second transformation to recover initially input three-phase data.

The instantaneous power three-phase to two-phase transformation processing unit may recover steady-state three-phase current when there is two-line short circuit on the three-phase current.

The details of one or more embodiments are set forth in the accompanying drawings and the description below. Other features will be apparent from the description and drawings, and from the claims.

**BRIEF DESCRIPTION OF THE DRAWINGS**

Fig. 1 is a diagram for explaining a typical high voltage direct current (HVDC) instantaneous power monitoring system.
Fig. 2 is a diagram for explaining an HVDC instantaneous power monitoring system to which an embodiment is applied.
Figs. 3 to 4b are diagrams for explaining an operation of processing HVDC instantaneous power data according to an embodiment.

Figs. 5a to 6c are exemplary diagrams for explaining HVDC instantaneous power data according to an embodiment.

**DETAILED DESCRIPTION OF THE EMBODIMENTS**

Particular embodiments are described below in detail with reference to the accompanying drawings.

The terms used herein are general terms being currently, widely used if possible, but in particular cases, terms arbitrarily selected by the applicant are used and in these cases, since their meanings are described in detail in corresponding parts of the detailed description, it should be noted that an embodiment needs to be understood with the meanings of the terms, not the names of the terms.

That is, in the following description, the word "including" does not exclude the presence of components or steps other than those enumerated.

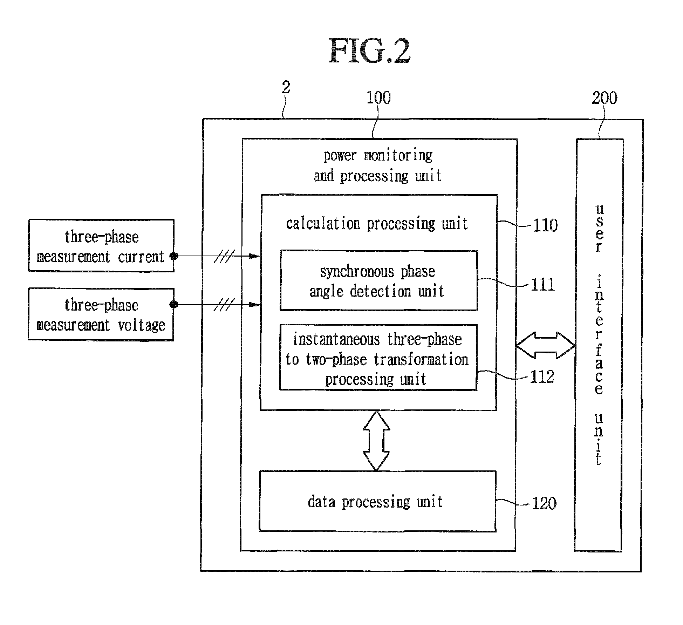

Fig. 2 is a diagram for explaining an HVDC instantaneous power monitoring system to which an embodiment is applied.

Referring to Fig. 2, an HVDC instantaneous power monitoring system 2 to which the embodiment is applied may include a power monitoring and processing unit 100 and a user interface unit 200.

The power monitoring and processing unit 100 includes a calculation processing unit 110 and a data processing unit 120.

The calculation processing unit 110 may receive a three-phase measurement current and a three-phase measurement voltage and transform them into two-phase DC current and voltage data through data transformation of a received current and voltage.

The calculation processing unit 110 may include a synchronous phase angle detection unit 111 and an instantaneous power three-phase to two-phase transformation processing unit 112.

The synchronous phase angle detection unit 111 may detect a synchronous phase angle from a three-phase current and voltage, and a detected synchronous phase angle may be applied to a first transformation value of instantaneous power to be used as a coefficient calculating a second transformation value.

The instantaneous power three-phase to two-phase transformation processing unit 112 may perform an operation for transforming two-phase current and voltage data through first and second transformation of the three-phase current and the three-phase voltage according to an embodiment.

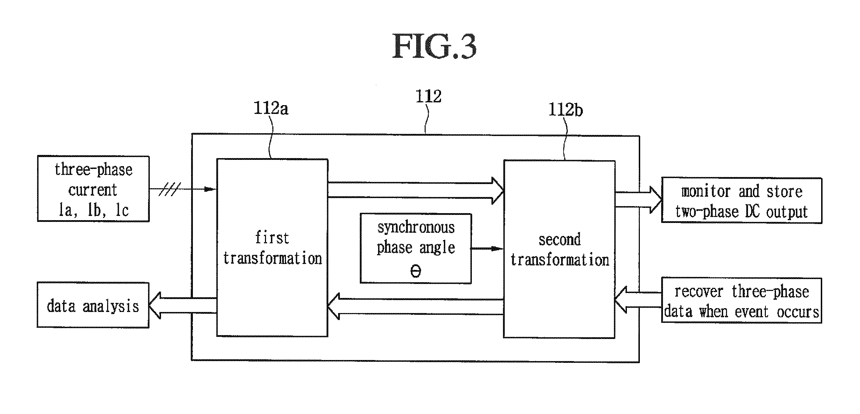

Figs. 3 to 4b are diagrams for explaining the processing operation of the instantaneous three-phase to two-phase transformation processing unit 112 for HVDC instantaneous power data according to an embodiment.

The transformation operation of instantaneous power monitoring data according to an embodiment is described in detail with reference to Figs. 3 to 4b.

The instantaneous power three-phase to two-phase transformation processing unit 112 may perform first transformation (e.g., Clarke transformation) and second transformation (e.g., Park transformation) based on three-phase current and three-phase voltage data to transform the data into second-phase instantaneous power data.

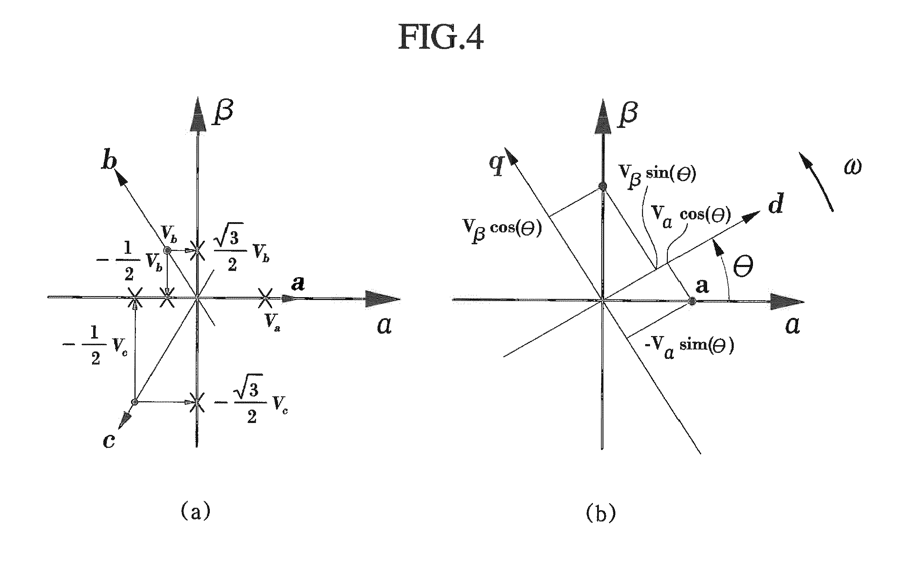

The instantaneous power three-phase to second-phase transformation processing unit 112 may receive three phase currents ia, ib and ic and transform the three phase currents at Clarke transformation unit 112a. In this case, the first transformation for transforming three-phase current and three-phase voltage data into second-phase instantaneous power data may be performed by Clarke transformation. The Clarke transformation transforms three phase currents a, b and c being stators into a stator Cartesian coordinate system having two values $\alpha$ and $\beta$ based on Equation 1 below and Fig. 4a.

<Equation 1>

$$\begin{bmatrix} i_0 \\ i_a \\ i_\beta \end{bmatrix} = \frac{2}{3} \begin{bmatrix} \dfrac{1}{\sqrt{2}} & \dfrac{1}{\sqrt{2}} & \dfrac{1}{\sqrt{2}} \\ 1 & -\dfrac{1}{2} & -\dfrac{1}{2} \\ 0 & \dfrac{\sqrt{3}}{2} & -\dfrac{\sqrt{3}}{2} \end{bmatrix} \begin{bmatrix} i_a \\ i_b \\ i_c \end{bmatrix}$$

That is, first transformation data transformed at the first transformation unit 112a may perform second transformation at the second transformation unit 112b by applying a synchronous phase angle $\theta$ detected by the phase angle detection unit 111 to the first transformation data.

The second transformation performed at the second transformation unit 112b may be performed by Park transformation. The Park transformation transforms a stator Cartesian coordinate system having two values $\alpha$ and $\beta$ into a rotary synchronous coordinate system having two values d and q based on Equation 2 below and Fig. 4b. In this case, a value $\theta$ detected by the synchronous phase angle detection unit 111 may represent the rotor flux location of d and q about $\alpha$ and $\beta$.

<Equation 2>

$$\begin{bmatrix} i_d \\ i_q \end{bmatrix} = \begin{bmatrix} \cos\theta & \sin\theta \\ -\sin\theta & \cos\theta \end{bmatrix} \begin{bmatrix} i_a \\ i_\beta \end{bmatrix}$$

Thus, when three-phase measurement current and three-phase measurement voltage values are input in an embodiment, the values of the three phases may be transformed into two-phase instantaneous power monitoring data through first and second transformation.

On the contrary, pre-transformed two-phase instantaneous power monitoring data may be transformed into three-phase current and three-phase voltage data through the inverse transformation of the first and second transformation.

The inverse transformation may be performed by the sequential application of Equations 3 and 4 below.

<Equation 3>

$$\begin{bmatrix} i_a \\ i_\beta \end{bmatrix} = \begin{bmatrix} \cos\theta & -\sin\theta \\ \sin\theta & \cos\theta \end{bmatrix} \begin{bmatrix} i_d \\ i_q \end{bmatrix}$$

<Equation 4>

$$\begin{bmatrix} i_a \\ i_b \\ i_c \end{bmatrix} = \begin{bmatrix} \dfrac{1}{\sqrt{2}} & 1 & 0 \\ \dfrac{1}{\sqrt{2}} & -\dfrac{1}{\sqrt{2}} & \dfrac{\sqrt{3}}{2} \\ \dfrac{1}{\sqrt{2}} & -\dfrac{1}{2} & \dfrac{\sqrt{3}}{2} \end{bmatrix} \begin{bmatrix} i_0 \\ i_a \\ i_\beta \end{bmatrix}$$

The data processing unit 120 may store the processing result of the calculation processing unit 110 or output pre-stored data to the calculation processing unit 110. The data processing unit 120 may be a storage unit that stores data processed according to an embodiment and data to be processed.

HVDC instantaneous power data according to an embodiment is described in detail with reference to Figs. 5s to 6c based on a configuration according to an embodiment as described above.

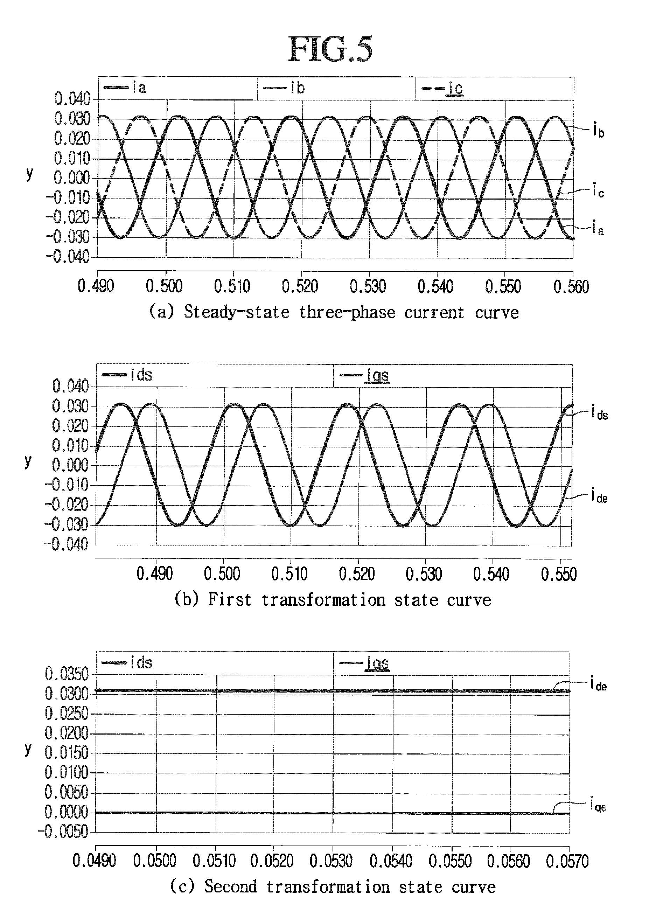

Figs. 5a to 6c are exemplary diagrams for explaining HVDC instantaneous power data according to an embodiment.

Fig. 5a is an exemplary diagram representing a three-phase current curve in a steady state according to an embodiment. When three phase currents ia, ib and ic are input as described above, it is possible to detect the synchronous phase angle θ by the synchronous phase angle detection unit 111 from the three phase currents as described above. The three phase currents experience first transformation at the instantaneous three-phase to two-phase transformation processing unit 112. When the three-phase currents complete the first transformation, they may be transformed into two phase currents ids and iqs as shown in Fig. 5b, and the two phase currents obtained through the first transformation may be output as two phase currents ide and iqe being DC through second transformation as shown in Fig. 5c. Thus, since two-phase balanced current data is output as described above, the amount of data decreases and it is easy to analyze, when compared to initially input current and voltage data.

Also, it is possible to recover initially input data from the two-phase data obtained through transformation as described above, through the inverse transformation of an operation of transforming three-phase data into two-phase data to monitor and analyze the state of data.

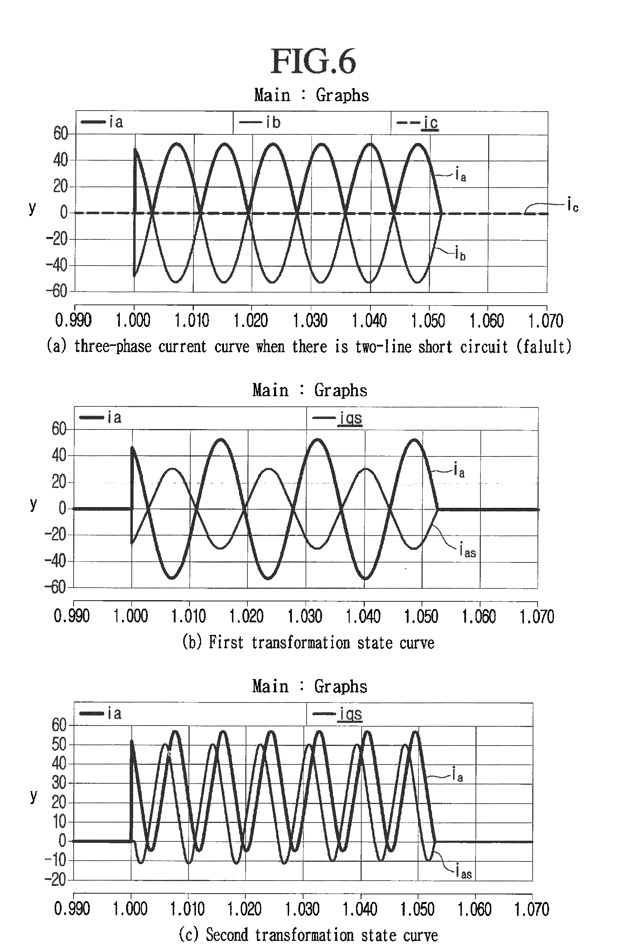

Fig. 6a is a three-phase current curve for a two-line short circuit (fault) unlike a steady state in Figs. 4a and 4b, Fig. 6b represents transformation into two phases through first transformation on input three phase currents and in Fig. 6c, it is possible to recover steady-state three-phase current easy to analyze through second transformation.

The HVDC instantaneous power monitoring system according to an embodiment may manage HVDC instantaneous power data and efficiently use a storage space of the monitoring system.

Also, the HVDC instantaneous power monitoring system according to an embodiment may store all collected data as long as data is not forcibly deleted, and thus may be efficiently used for history management for accidents and events.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

**Claims**

1. A high voltage direct current (HVDC) instantaneous power monitoring system comprising:

   a calculation processing unit(11) receiving three-phase current and voltage, detecting a synchronous phase angle from received three-phase current and voltage, and transforming two-phase data into two-phase data to output the two-phase data; and
   a data processing unit(12) storing data transformed at the calculation processing unit.

2. The high voltage direct current (HVDC) instantaneous power monitoring system according to claim 1, wherein the calculation processing unit(11) comprises a synchronous phase angle detection unit(111) detecting a synchronous phase angle from the three-phase current and voltage.

3. The high voltage direct current (HVDC) instantaneous power monitoring system according to claim 1, wherein the calculation processing unit(11) comprises an instantaneous power three-phase to two-phase transformation processing unit(112) performing first and second transformation on the three-phase data.

4. The high voltage direct current (HVDC) instantaneous power monitoring system according to claim 3, wherein the instantaneous power three-phase to two-phase transformation processing unit(112) transforms the three-phase data into two-phase Cartesian coordinate system data through Clarke transformation corresponding to the first transformation, and
   transforms data obtained through the first transformation into a two-phase rotary synchronous coordinate system through Park transformation corresponding to the second transformation.

5. The high voltage direct current (HVDC) instantaneous power monitoring system according to claim 4, wherein the Park transformation is performed based on the synchronous phase angle detected by the synchronous phase angle detection unit(111).

6. The high voltage direct current (HVDC) instantaneous power monitoring system according to claim 4, wherein the first transformation transforms the three-phase current into two-phase current, and
   the second transformation transforms the two-phase current obtained through the transformation into two-phase current being a DC.

7. The high voltage direct current (HVDC) instantaneous power monitoring system according to claim 3,

**EP 2 940 481 A1**

wherein the instantaneous power three-phase to two-phase transformation processing unit(112) inversely performs the first and second transformation on the two-phase current obtained through the first and second transformation to recover initially input three-phase data.

8. The high voltage direct current (HVDC) instantaneous power monitoring system according to claim 7, wherein the instantaneous power three-phase to two-phase transformation processing unit(112) recovers steady-state three-phase current when there is two-line short circuit on the three-phase current.

9. The high voltage direct current (HVDC) instantaneous power monitoring system according to claim 1, further comprising a user interface unit(200).

10. The high voltage direct current (HVDC) instantaneous power monitoring system according to claim 1, wherein the data processing unit(12) outputs pre-stored data to the calculation processing unit(11).

# FIG.1

# FIG.2

three-phase measurement current

three-phase measurement voltage

2

100

power monitoring and processing unit

calculation processing unit ——110

synchronous phase angle detection unit ——111

instantaneous three-phase to two-phase transformation processing unit ——112

data processing unit ——120

200

user interface unit

# FIG.3

112a     112     112b

three-phase
current
Ia, Ib, Ic

first
transformation

synchronous
phase angle
Θ

second
transformation

monitor and store
two-phase DC output

data analysis

recover three-phase
data when event occurs

EP 2 940 481 A1

# FIG.4

(a)

(b)

EP 2 940 481 A1

# FIG.5

(a) Steady-state three-phase current curve

(b) First transformation state curve

(c) Second transformation state curve

# FIG.6

Main : Graphs

(a) three-phase current curve when there is two-line short circuit (falult)

Main : Graphs

(b) First transformation state curve

Main : Graphs

(c) Second transformation state curve

**EP 2 940 481 A1**

## EUROPEAN SEARCH REPORT

Application Number

EP 15 16 5335

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/130335 A1 (YUZURIHARA ITSUO [JP] ET AL) 5 June 2008 (2008-06-05) | 1-3,7-10 | INV. G01R19/25 |
| A | * paragraph [0135] - paragraph [0188] * ----- | 4-6 | G01R21/133 H02M7/00 |
| A | VLADIMIR BLASKO ET AL: "A New Mathematical Model and Control of a Three-Phase AC-DC Voltage Source Converter", IEEE TRANSACTIONS ON POWER ELECTRONICS, INSTITUTE OF ELECTRICAL AND ELECTRONICS ENGINEERS, USA, vol. 12, no. 1, 1 January 1997 (1997-01-01), XP011043008, ISSN: 0885-8993 * the whole document * ----- | 1-10 | |
| A | US 2014/062457 A1 (ZHENG PING [CN]) 6 March 2014 (2014-03-06) * paragraph [0052] - paragraph [0098] * ----- | 1-10 | |

TECHNICAL FIELDS SEARCHED (IPC)

H02M
G01R

The present search report has been drawn up for all claims

| Place of search | Date of completion of the search | Examiner |
|---|---|---|
| Munich | 18 September 2015 | Meggyesi, Zoltán |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................
& : member of the same patent family, corresponding document

EPO FORM 1503 03.82 (P04C01)

**ANNEX TO THE EUROPEAN SEARCH REPORT**
**ON EUROPEAN PATENT APPLICATION NO.**

EP 15 16 5335

This annex lists the patent family members relating to the patent documents cited in the above-mentioned European search report.
The members are as contained in the European Patent Office EDP file on
The European Patent Office is in no way liable for these particulars which are merely given for the purpose of information.

18-09-2015

| Patent document cited in search report | | Publication date | Patent family member(s) | | Publication date |
|---|---|---|---|---|---|
| US 2008130335 | A1 | 05-06-2008 | CN | 101197506 A | 11-06-2008 |
| | | | DE | 102007013227 A1 | 05-06-2008 |
| | | | JP | 5259077 B2 | 07-08-2013 |
| | | | JP | 2008141887 A | 19-06-2008 |
| | | | KR | 20080050997 A | 10-06-2008 |
| | | | TW | 200826464 A | 16-06-2008 |
| | | | US | 2008130335 A1 | 05-06-2008 |
| US 2014062457 | A1 | 06-03-2014 | CN | 102680806 A | 19-09-2012 |
| | | | US | 2014062457 A1 | 06-03-2014 |
| | | | WO | 2013155844 A1 | 24-10-2013 |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020140051552